Europäisches Patentamt

European Patent Office

Office européen des brevets

(19)

(11) Numéro de publication : **0 197 438 B2**

## (12) NOUVEAU FASCICULE DE BREVET EUROPEEN

(45) Date de publication du nouveau fascicule du brevet : **23.08.95 Bulletin 95/34**

(51) Int. Cl.⁶ : **G06K 19/06, H01L 23/48**

(21) Numéro de dépôt : **86104178.8**

(22) Date de dépôt : **26.03.86**

(54) **Procédé de fabrication de modules électroniques pour cartes à microcircuits et modules obtenus selon ce procédé.**

(30) Priorité : **02.04.85 FR 8505109**

(43) Date de publication de la demande : **15.10.86 Bulletin 86/42**

(45) Mention de la délivrance du brevet : **20.06.90 Bulletin 90/25**

(45) Mention de la décision concernant l'opposition : **23.08.95 Bulletin 95/34**

(84) Etats contractants désignés : **AT CH DE GB IT LI NL SE**

(56) Documents cités :
**EP-A- 0 128 822**
**DE-A- 3 029 667**

(56) Documents cités :
**DE-A- 3 046 192**
**FR-A- 2 488 446**
**FR-A- 2 495 839**
**FR-A- 2 548 857**
**GB-A- 2 149 209**
**GB-B- 1 524 776**

(73) Titulaire : **Eta SA Fabriques d'Ebauches**
**Schild-Rust-Strasse 17**
**CH-2540 Granges (CH)**

(72) Inventeur : **Stampfli, Jean-Marcel**
**Chantemerle 3**
**CH-2525 Le Landeron (CH)**

(74) Mandataire : **Barbeaux, Bernard et al**
**ICB**
**Ingénieurs Conseils en Brevets SA**
**Rue des Sors 7**
**CH-2074 Marin (CH)**

EP 0 197 438 B2

Jouve, 18, rue Saint-Denis, 75001 PARIS

# Description

La présente invention a pour objet un procédé de fabrication de modules électroniques pour cartes à microcircuits telles que cartes de crédit, cartes bancaires, cartes de parking, cartes de paiement pour des appels téléphoniques dans des cabines publiques, etc., et les modules obtenus par la mise en oeuvre de ce procédé.

Telles qu'elles sont connues actuellement, les cartes à microcircuits appelées aussi cartes à mémoire ou cartes intelligentes comprennent généralement, comme circuit électronique, une mémoire et un microprocesseur intégrés sous forme d'une seule puce ou de deux puces connectées entre elles par des conducteurs électriques et un ensemble de plages de contact, souvent au nombre de huit, qui sont reliées au microprocesseur et qui sont accessibles pour les pièces de connexion d'un appareil, par exemple un terminal d'ordinateur, dans lequel la carte est destinée à être introduite.

Dans certains cas, ces différents éléments sont, à l'exception des plages de contact, noyés dans un corps isolant homogène ou composite pour former une pastille qui est ensuite placée dans une ouverture correspondante du corps de la carte. Dans d'autres, ils sont directement incorporés dans ce dernier.

Indépendamment des questions liées au circuit intégré lui-même, comme par exemple celles de savoir quelles infomations la mémoire doit contenir, quelles fonctions doit remplir le microprocesseur, de quelle façon doivent être conçus cette mémoire et ce microprocesseur, l'introduction d'un circuit électronique dans une carte de transaction pose un certain nombre de problèmes, notamment à cause des exigences assez nombreuses auxquelles elles doivent répondre.

Tout d'abord, une carte de paiement à microcircuits doit avoir le même format qu'une carte classique à pistes magnétiques standardisée dont la longueur est de 85 mm, la largeur de 54 mm et l'épaisseur de 0,76 mm (normes ISO) ou tout au moins des dimensions voisines pour rester peu encombrante et facilement maniable.

Si l'on se rend compte que, premièrement, une épaisseur de 760 microns ne correspond grossièrement qu'à deux fois celle d'une puce de circuit intégré sans protection, que, deuxièmement, la portion de la surface de la carte qui peut être allouée au circuit électronique est très limitée étant donné que la majeure partie de celle-ci doit être réservée à des inscriptions telles que la dénomination du prestataire qui délivre la carte, l'identité du porteur, une signature, des informations d'utilisation et éventuellement une photo et que, troisièmement, les plages conductrices doivent être suffisamment grandes pour que le contact avec les pièces de connexion d'un appareil soit assuré et bon, on en déduit très vite que l'on ne peut utiliser des circuits standardisés déjà enrobés ou emboîtés comme ceux que l'on trouve actuellement sur le marché et qui sont trop volumineux.

On est donc obligé, pour fabriquer les cartes ou les modules électroniques qui leur sont destinés, de partir de puces de circuits intégrés nues, de réaliser soi-même le réseau d'interconnexion qui permet de relier électriquement ces puces avec l'extérieur et entre elles s'il y en a plusieurs dans une même carte et d'assurer la protection de l'ensemble qui est naturellement très fragile surtout au niveau des jonctions entre les pièces conductrices (bornes de connexion des puces, fils, etc.).

Cette protection doit être d'autant plus efficace que les cartes seront forcément amenées à subir très souvent des déformations qui pourront être importantes du fait que l'on demande à ces cartes, comme aux cartes classiques, de répondre à des normes ou à des exigences de flexibilité relativement sévères et elle ne peut pas être assurée en donnant, aux modules électroniques ou aux zones des cartes dans lesquelles les circuits sont placés, la plus grande rigidité possible car les conditions de flexibilité en question ne seraient alors plus remplies.

Par ailleurs, il faut éviter que des agents extérieurs, comme la lumière ou l'humidité puissent venir détériorer le circuit ou en perturber le fonctionnement.

Enfin, il est bien clair que les cartes doivent pouvoir être fabriquées en grande série et à un prix de revient très bas, surtout s'il s'agit de cartes auxquelles est attribuée initialement une certaine valeur que l'on paie en les achetant et qui, lorsque cette valeur est épuisée, doivent tout simplement être jetées.

Cela dit, les solutions qui ont déjà été imaginées pour tenter de régler ces différents problèmes et qui consistent à réaliser en grande série des modules électroniques destinés à être placés ensuite dans des corps de cartes sont nombreuses et très variées et deux d'entre elles méritent d'être signalées ici. Ce sont celle qui est décrite dans le document GB-A-2 149 209 et l'une de celles que l'on trouve dans le document EP-A-0 128 822.

Lorsque l'on adopte la solution du document GB-A-2 149 209 on se munit d'un film-support en matière isolante et on découpe dans celui-ci des fenêtres régulièrement espacées, destinées à recevoir chacune une puce de circuit intégré et les conducteurs de liaison entre les bornes de connexion de cette puce et ce qui constituera plus tard les plages de contact d'un module. Ensuite, on plaque sur l'une des faces de ce film-support un film métallique beaucoup plus mince que l'on grave pour y former les plages de contact en question, on fixe une puce dans chaque fenêtre en collant sa face arrière sur le film métallique, on relie les bornes de cette puce aux plages correspondantes par la technique du "Wire-Bonding", on remplit les fenêtres et les rainures qui séparent les plages du reste du film métallique et entre elles d'une résine opaque et, enfin, on découpe le film-support et le film métallique pour obtenir des modules.

Cette façon de procéder permet de réaliser des modules en ne faisant appel qu'à des techniques de fabrication que l'on maîtrise maintenant très bien dans le domaine de l'électronique, ce qui est un avantage, mais elle présente aussi des inconvénients.

Tout d'abord il n'est pas possible d'obtenir de cette manière des modules vraiment bon marché et ceci pour au moins deux raisons. La première c'est que les films-supports que l'on est amené à utiliser et qui sont constitués par des matières isolantes comme celle qui est commercialisée sous la marque "KAPTON" coûtent cher. La deuxième raison c'est que, pour former les plages de contact on ne peut pas faire autrement que d'employer des techniques de gravure chimique ou photochimique, comme la photolithographie, qui nécessitent à elles seules plusieurs opérations et qui sont longues et coûteuses.

D'autre part, les modules en question sont relativement fragiles. En effet, si les cartes dans lesquelles ils sont placés sont soumises à des déformations fréquentes et importantes les plages de contact peuvent se désolidariser au moins partiellement de leurs supports isolants et les soudures des conducteurs sur ces plages peuvent se rompre.

De plus, l'opération d'attaque chimique du film métallique lors de la formation des plages peut provoquer une pollution ionique du film-support et diminuer la fiabilité à long terme des modules.

La solution du document EP-A-0 128 822 est très proche de celle dont on vient de parler. Il n'y a en fait que trois différences entre les deux.

La première différence, qui est minime, c'est qu'après s'être procuré un film-support en matière isolante on ne découpe pas seulement dans celui-ci des fenêtres uniques, régulièrement espacées mais des ensembles comprenant chacun une fenêtre centrale destinée à recevoir une puce de circuit intégré et des fenêtres périphériques plus petites pour le passage des fils conducteurs qui relieront ensuite les bornes de cette puce aux plages de contact.

La deuxième différence c'est que l'épaisseur du film-support est inférieure à celle des puces, ce qui fait que lorsque les modules sont terminés leur puce et leurs fils de connexion ressortent largement du côté de leur face arrière, c'est-à-dire du côté opposé à celui où se trouvent leurs plages de contact.

Enfin, la troisième différence c'est que l'on ne prend plus dans ce cas le soin de noyer les puces et les fils de connexion dans une matière adhésive durcissable et opaque ce qui fait que toutes les parties fragiles des modules ne sont pas protégées tant que ceux-ci ne sont pas incorporés dans des cartes et que cette solution du document EP-A-0 128 822 présente un inconvénient de plus que celle du document GBA-2 149 209.

L'invention a pour but de fournir un procédé qui permet de réaliser des modules électroniques en grand nombre, en partant de produits assez bon marché, en n'effectuant que peu d'opérations et en utilisant également des techniques de fabrication bien connues dans le domaine de l'électronique, autrement dit un procédé qui permet de produire des modules électroniques à un prix de revient vraiment bas.

Un autre but de l'invention est que ces modules soient très fiables c'est-à-dire capables de très bien résister à toutes les contraintes et à toutes les attaques auxquelles ils seront soumis lorsqu'ils seront ensuite incorporés dans des corps de cartes.

Ces but sont atteints grâce au fait que, conformément à l'invention, pour fabriquer des modules électroniques qui comprennent une puce de circuit intégré avec une face avant munie de bornes de connexion et une face arrière et un ensemble de plages de contact métalliques reliées chacune à l'une des bornes de connexion de la puce:

- on se munit d'une grille métallique comportant une pluralité d'ouvertures identiques délimitées par un cadre et, dans chaque ouverture, un ensemble de languettes rattachées au cadre et destinées à former les plages de contact d'un module;
- on se munit également d'une série de pastilles en matière synthétique plus petites que les ouvertures de la grille, chaque pastille ayant une face avant sensiblement plane, une face arrière du côté de laquelle elle présente un évidement et, entre cet évidement et ladite face avant, des fenêtres prévues pour pouvoir être amenées chacune au droit d'une languette d'un ensemble;
- on fixe une pastille par sa face avant sur chaque ensemble de languettes de façon que les fenêtres en question se trouvent effectivement au droit de ces languettes;
- on fixe une puce de circuit intégré au fond de l'évidement de chaque pastille de façon que sa face arrière soit orientée vers la grille;
- on relie les bornes de connexion de la puce aux languettes sur lesquelles la pastille est fixée, au moyen de conducteurs logés dans l'évidement de la pastille et passant par les fenêtres; et
- on remplit l'évidement et les fenêtres de chaque pastille d'un matériau adhésif durcissable électriquement isolant.

Pour fixer les puces à l'intérieur des pastilles et relier leurs bornes de connexion aux languettes, on peut soit commencer par coller chaque puce dans le fond de l'évidement d'une pastille et souder ensuite chaque conducteur d'abord sur une borne de connexion de cette puce puis sur la languette correspondante de la grille, soit commencer par souder les conducteurs par une de leurs extrémités sur les bornes de connexion des puces, coller ensuite ces dernières dans le fond des évidements des pastilles et enfin souder les autres extrémités des conducteurs sur les languettes.

Lorsque les modules sont terminés, on peut les détacher soi-même de la grille en découpant les languettes autour de chaque pastille, ou bien laisser ce soin à celui qui achète ces modules pour les incorporer dans des cartes.

D'autres caractéristiques et avantages de l'invention apparaîtront au cours de la description détaillée mais non limitative qui suit de deux manières possibles de la mettre en oeuvre.

Cette description sera faite en référence aux dessins annexés parmi lesquels:

- la figure 1 montre partiellement, en plan, une grille que l'on fabrique conformément au premier de ces modes de mise en oeuvre de l'invention;
- les figures $2_a$ et $2_b$ sont des vues respectivement de dos et de face d'une pastille en matière plastique qui est également réalisée conformément à ce même mode;
- la figure $2_c$ est une vue en coupe de la pastille selon la ligne brisée II-II de la figure $2_a$;
- la figure 3 montre comment des pastilles comme celle des figures $2_a$ à $2_c$ sont fixées sur des languettes de la grille de la figure 1 qui sont destinées à former les plages de contact des modules;
- la figure 4 est une vue partielle et agrandie de la grille de la figure 1 qui montre les ergots dont les languettes sont munies lorsque les pastilles sont soudées sur la grille par ultrasons;
- la figure $5_a$ est une vue partielle en plan d'une languette de la figure 4 qui permet de mieux montrer la forme des ergots;
- la figure $5_b$ montre, vue par le haut, la languette de la figure $5_a$, lorsque les ergots sont repliés à angle droit;
- la figure $6_a$ montre une pastille vue partiellement de dos, avec une puce de circuit intégré et les connexion entre les bornes de cette dernière et les languettes de la grille après que celles-ci aient été réalisées;
- la figure $6_b$ est une vue en coupe suivant la ligne brisée VI-VI de la figure $6_a$;

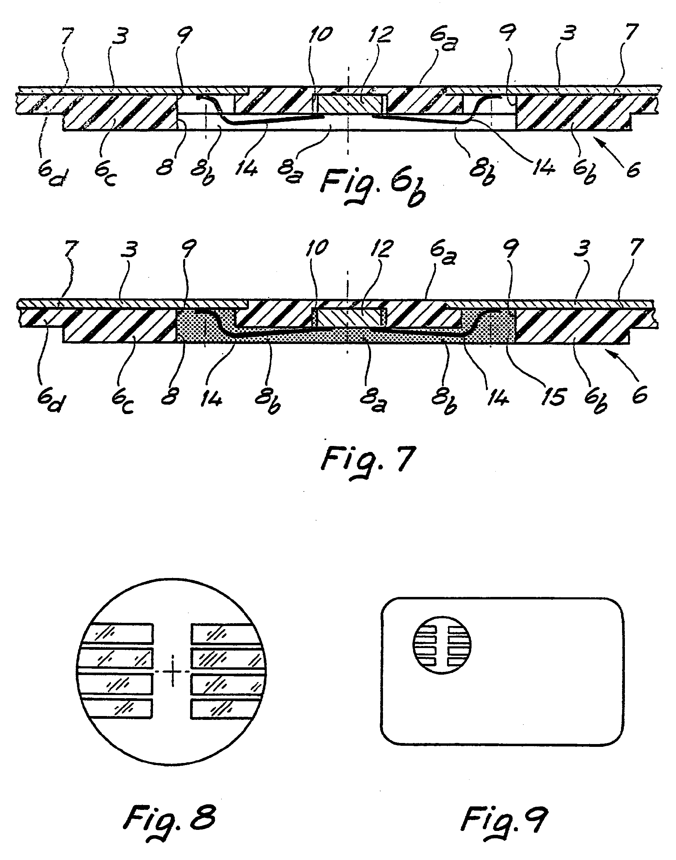

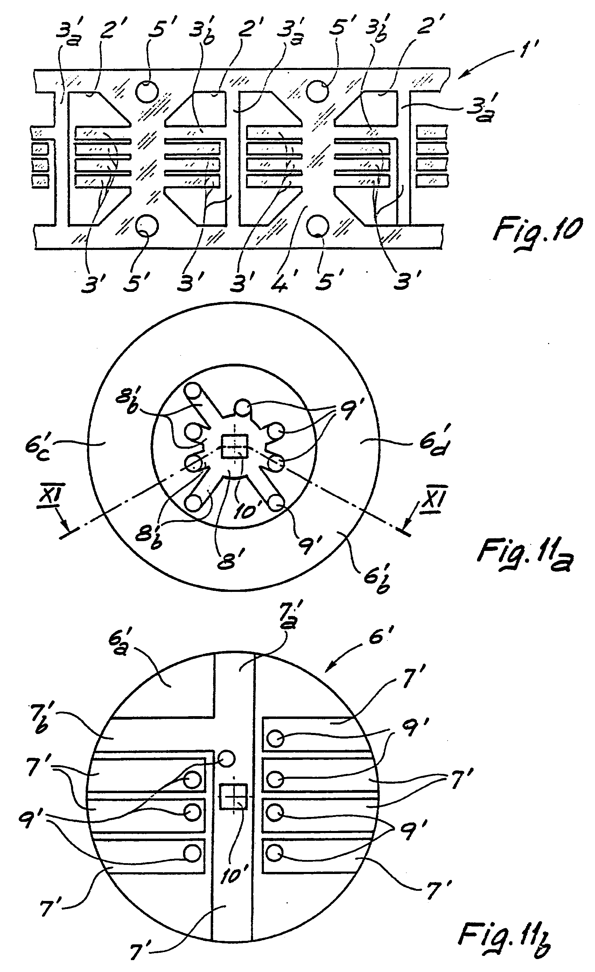

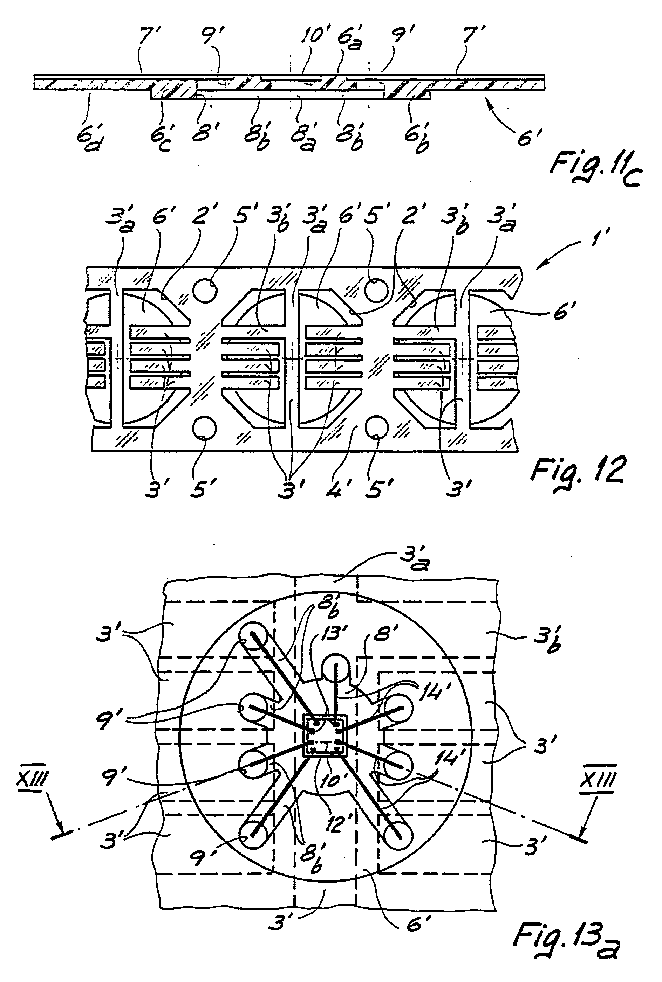

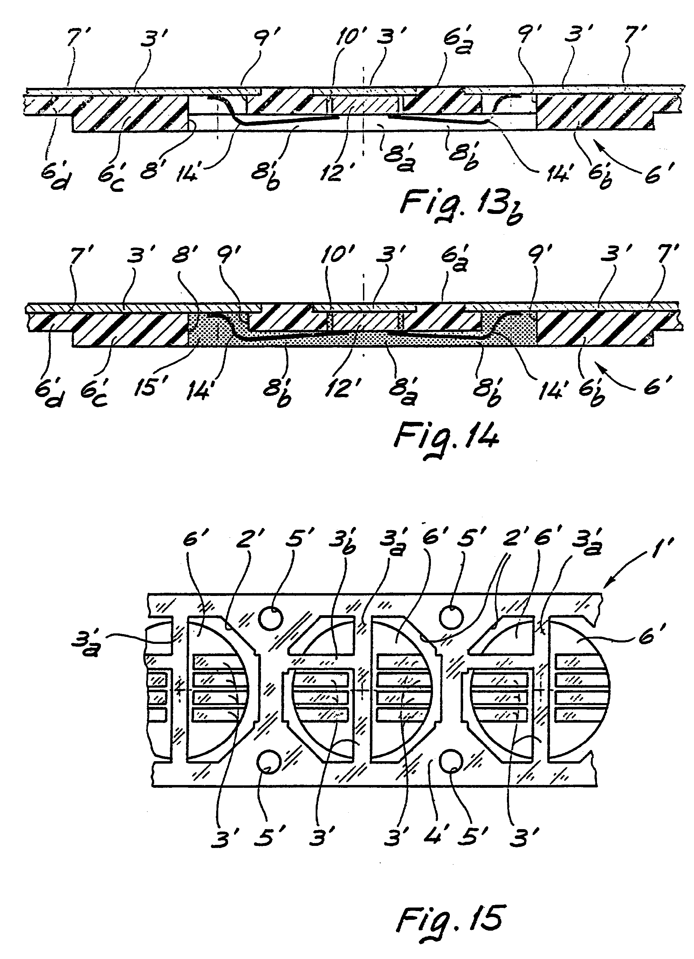

- la figure 7 est une vue en coupe semblable à celle de la figure $6_b$ qui montre un module terminé;
- la figure 8 est une vue de face de ce dernier;
- la figure 9 montre schématiquement le module incorporé dans une carte;

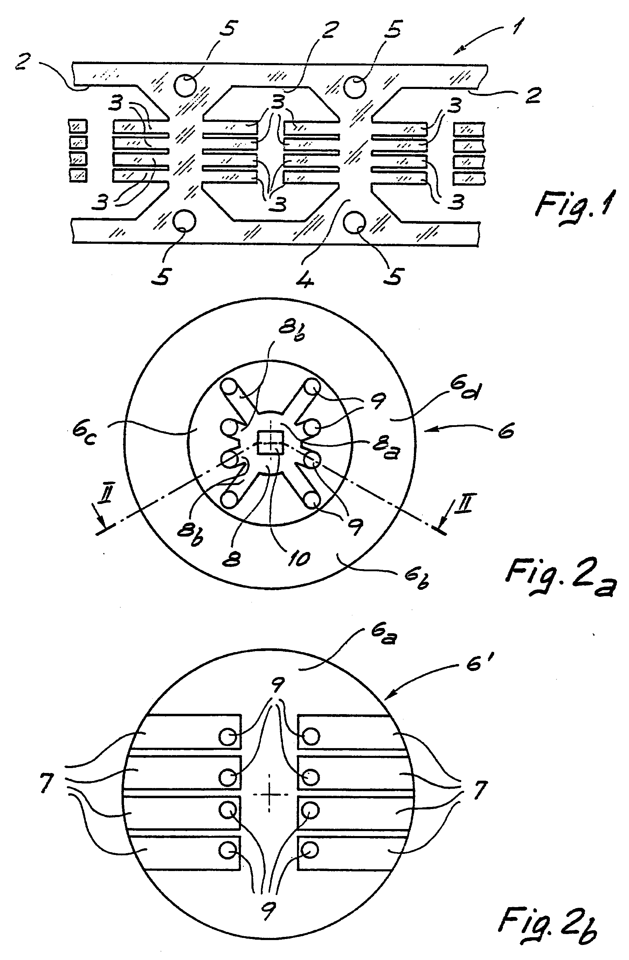

- les figures 10, $11_a$, $11_b$, $11_c$, 12, $13_a$, $13_b$ et 14 sont des vues analogues respectivement à celles des figures 1, $2_a$, $2_b$, $2_c$, 3, $6_a$, $6_b$ et 7 qui illustrent le deuxième mode de mise en oeuvre de l'invention; et
- la figure 15 montre comment dans ce deuxième mode les modules peuvent être laissés attachés au cadre de la grille pour être testés et livrés en bande.

Pour réaliser des modules électroniques conformément au premier mode de mise en oeuvre du procédé selon l'invention que l'on a choisi de décrire, on commence par fabriquer une grille métallique 1 en forme de bande, comme celle que montre partiellement la figure 1 et des pastilles 6 en matière synthétique comme celle des figures $2_a$, $2_b$ et $2_c$.

La grille 1 est destinée non seulement à former les plages de contact des modules mais également à supporter ces derniers, à les déplacer sur une machine et à les transférer d'une machine à une autre, ceci tout au long de leur fabrication afin que celle-ci puisse se faire de la manière la plus automatisée possible.

Pour cela, la grille 1 présente, d'une part, dans sa partie centrale, une pluralité d'ouvertures identiques 2 régulièrement réparties dans le sens de sa longueur et dans chacune desquelles pénètrent des languettes 3 rattachées à un bout au cadre 4 de la grille et libres à l'autre qui constitueront les plages de contact et, d'autre part, le long de chacun de ses bords, une série de perforations équidistantes 5 qui permettront de la positionner et de la faire défiler pas à pas devant les différents outils qui seront utilisés pour la réalisation des modules.

Telles qu'elles sont représentées sur la figure, les ouvertures 2 sont octogonales, les perforations 5 se trouvent entre ces ouvertures et les languettes 3 qui sont au nombre de huit par ouverture ont toutes la même forme rectangulaire et les mêmes dimensions et sont disposées à la fois parallèlement aux bords de la grille et symétriquement par rapport aux plans médians des ouvertures qui sont perpendiculaires à ces derniers.

Naturellement, ceci n'est qu'un exemple de configuration que peut avoir la grille. La forme des ouvertures et la position des perforations par rapport à celles-ci pourraient être différentes sans que cela change quoi que ce soit au procédé de fabrication des modules. Il en est de même en ce qui concerne le nombre des languettes, leur forme et leur disposition dans les ouvertures, bien que ceux qui ont été choisis correspondent en fait au dessin des plages de contact qui est actuellement le plus répandu et qui s'impose de plus en plus dans le cas des cartes de transactions.

Quel que soit le modèle de grille que l'on retient, on peut toujours réaliser celle-ci facilement en partant d'un ruban métallique que l'on découpe de façon classique, mécaniquement ou par attaque chimique.

De préférence, on choisit un ruban qui possède déjà les qualités que devront présenter les plages des modules, à savoir une bonne résistance à la fois à l'usure par contact ou par frottement et à la corrosion atmosphérique ou par d'autres agents susceptibles de les détériorer.

Il peut s'agir par exemple d'un ruban de cuivre nickelé et doré ou mieux d'un alliage inoxydable comme le maillechort et notamment de celui que est commercialisé sous la marque "ARCAP" par la société française ARCAP Anticorrosion et qui se compose d'environ 56 % de cuivre, 25 % de nickel, 17 % de zinc et 2 % de métaux additionnels.

Grâce à ce choix, on évite d'avoir à traiter galvaniquement sinon la grille toute entière, du moins les parties qui formeront les plages de contact.

Quant aux pastilles 6, elles sont de préférence moulées par injection en utilisant une matière thermoplastique qui présente sensiblement les mêmes caractéristiques d'élasticité que celle qui servira à fabriquer les corps de cartes dans lesquels les modules seront insérés et qui sera le plus souvent du chlorure de polyvinyle désigné couramment par l'abréviation PVC. De plus, cette matière doit être un très bon isolant électrique et ne pas risquer de perdre cette qualité en absorbant de l'eau ou d'autres substances avec lesquelles les cartes pourront être amenées en contact. Il peut s'agir par exemple du polysulfure de phénylène (PPS) ou d'un autre polysulfure, d'un polysulfone, d'un polycarbonate, d'un polyester qui répond aux exigences qui viennent d'être indiquées.

Chaque pastille 6 se présente sous la forme d'un disque légèrement plus petit que les ouvertures 2 de la grille 1, dont l'une des faces $6_a$ est essentiellement plane et qui a une partie centrale circulaire $6_c$ plus épaisse que la partie périphérique $6_d$ qui l'entoure. Par exemple, le diamètre de la partie centrale $6_c$ peut être, en gros, la moitié de celui du disque et son épaisseur environ une fois et demi celle de la partie périphérique $6_d$.

Comme le montre la figure $2_b$, la pastille présente du côté de la face plane ou face avant $6_a$ de la pastille des gorges 7 peu profondes qui sont prévues pour recevoir les languettes 3 de l'une quelconque des ouvertures de la grille.

La forme, la grandeur et la profondeur de ces gorges sont telles que les languettes puissent les combler totalement, sans en sortir.

Par ailleurs, comme on peut le voir sur les figures $2_a$ et $2_c$, la pastille présente également du côté de sa face arrière $6_b$ un évidement 8 formé par un espace central $8_a$ et par une série de rainures $8_b$ en étoile qui partent de cet espace et qui se prolongent jusqu'à des fenêtres 9 qui sont prévues entre l'évidement et la face avant $6_a$ de la pastille et qui débouchent chacune dans l'une des gorges 7.

Enfin, au fond de l'évidement 8 et au centre de celui-ci se trouve une cavité 10 destinée à loger une puce de circuit intégré.

A noter que l'on pourrait aussi imaginer de donner à l'évidement 8 une forme plus simple, par exemple ronde ou rectangulaire, les fenêtres 9 continuant à se trouver au fond de celui-ci.

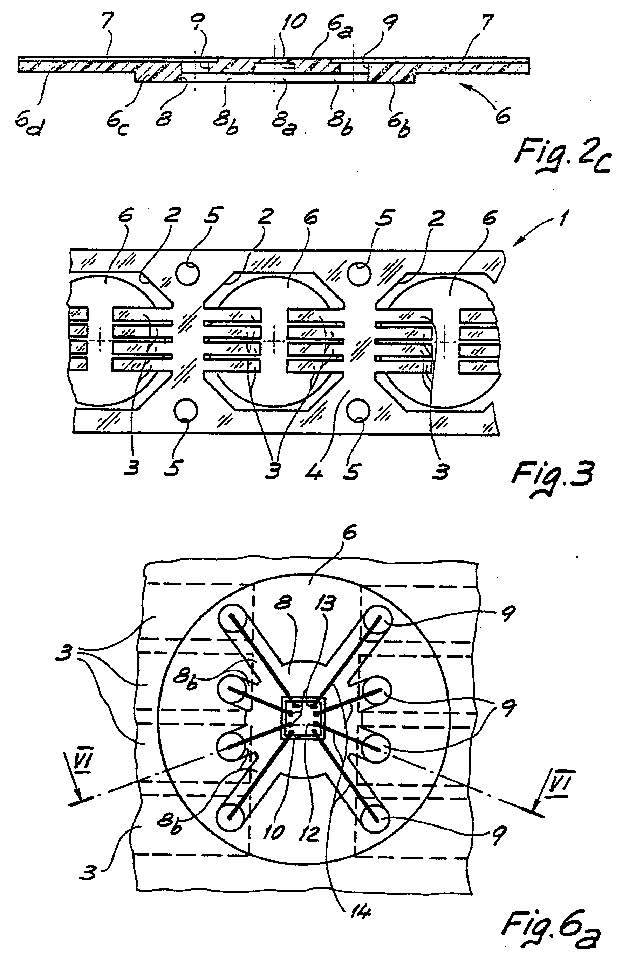

Lorsque l'on dispose de la grille 1 et des pastilles 6, on fixe chacune de ces pastilles par sa face avant $6_a$ sur les languettes 3 d'une ouverture 2 de la grille, de façon que ces dernières se trouvent dans les gorges 7 de la pastille prévues pour les recevoir, comme le monbre la figure 3.

Cette fixation peut se faire par collage ou par thermosoudage mais il est préférable pour cela de faire appel à la technique du soudage par ultrasons qui permet d'assurer une liaison beaucoup plus solide entre les languettes et la pastille.

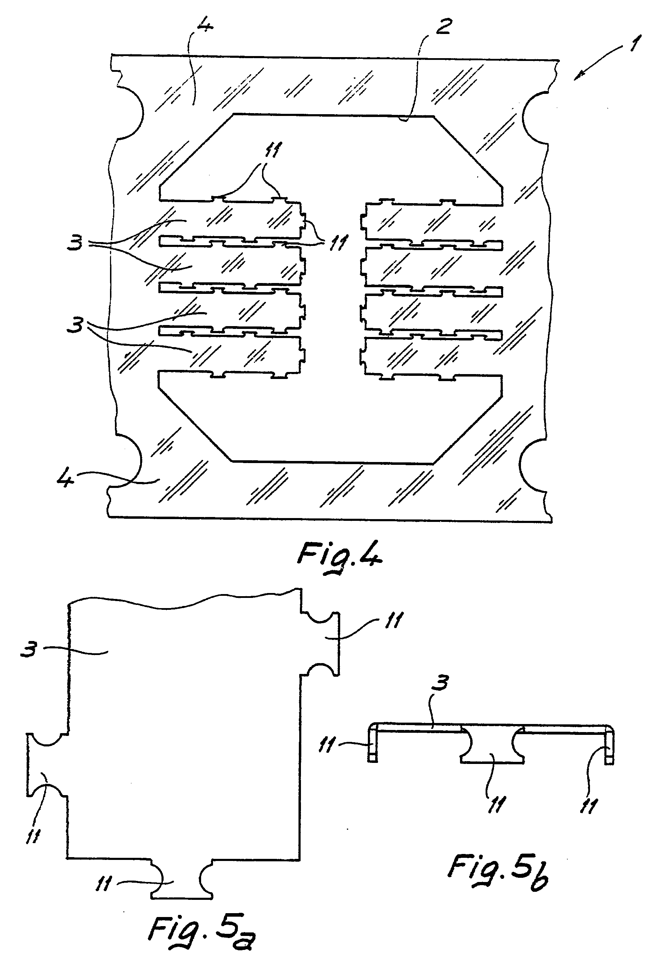

Si l'on décide d'utiliser effectivement cette méthode de soudage, on prévoit au moment de la réalisation de la grille des ergots 11 répartis autour de chaque languette, comme on peut le voir sur la vue agrandie de la figure 4. Il peut y avoir par exemple cinq ergots par languette, deux de chaque côté de celle-ci et un au bout.

Pour une raison qui apparaîtra par la suite, il est avantageux de donner aux côtés de ces ergots une forme incurvée ou en V, comme le montre la figure $5_a$, de façon qu'ils soient plus étroits au centre qu'aux extrémités.

Après que la grille ait été découpée, ces ergots sont repliés à 90° du côté où se trouveront les pastilles, ce qui est illustré par la figure $5_b$.

Ainsi, lorsqu'après avoir amené une pastille en regard d'une ouverture de la grille, on pressera sur les languettes 3 en les soumettant à des vibrations ultrasonores, cela provoquera un échauffement de la matière plastique principalement au voisinage des ergots et un ramollissement de celle-ci dans ces zones. Les ergots pourront alors pénétrer facilement dans la matière et lorsqu'après l'opération de soudage celle-ci sera redevenue solide ils y seront solidement ancrés, surtout si, plutôt que d'avoir simplement des côtés droits, ils ont la forme indiquée précédemment ou une forme équivalente par exemple celle d'un trapèze dont la petite base se trouverait du côté de la languette à laquelle ils sont rattachés.

Suivant l'appareillage dont on dispose ou que l'on a prévu pour fabriquer les modules, on peut soit fixer d'abord toutes les pastilles sur la grille avant de passer à la phase suivante et faire ensuite de même pour toutes les autres opérations, soit utiliser la méthode du travail à la chaîne, c'est-à-dire ne pas attendre qu'une opération soit complètement terminée pour commencer la suivante et arriver ainsi à en exécuter plusieurs en même temps sur des unités différentes. Pour la suite, on supposera que l'on se trouve dans le premier cas.

Donc, après avoir fixé les pastilles sur la grille, il s'agit de coller dans le logement 10 de chacune de celle-ci qui lui est réservé une puce de circuit intégré 12 (voir figures $6_a$ et $6_b$) de façon naturellement que sa face avant munie de bornes de connexion 13 se trouve du côté opposé à la grille et de relier chacune de ces bornes à une languette 3, en faisant passer un conducteur 14 dans une rainure $8_b$ et dans l'ouverture correspondante 9 et en veillant à ce qu'aucune partie de ce conducteur ne sorte de l'évidement 8.

Pour cela on peut procéder de deux façons. La première solution consiste à coller tout d'abord la puce 12 dans son logement et à utiliser ensuite la technique de la connexion par fil plus connu sous l'appellation anglaise de "Wire Bonding" pour souder un premier fil fin par exemple en aluminium d'abord sur une borne de connexion de la puce qui se présente alors sous la forme d'une plage et ensuite sur la languette correspondante de la grille, puis souder un deuxième fil sur une autre borne de la puce et sur une autre languette et ainsi de suite.

L'autre possibilité est de commencer par munir la puce de pattes de connexion soudées sur ses bornes qui sont alors des plots, ce qui peut être fait en employant l'une des techniques désignées généralement par les expressions anglaises "Beam Lead", "Tape Automated Bonding" (abréviation T.A.B.) et "Flip Chip" qui sont bien connues, de placer ensuite l'ensemble dans l'évidement 8 de la pastille tout en collant la puce dans son logement, les pattes de connexion étant bien entendu disposées de façon à se trouver dans les rainures $8_b$, et enfin de souder les extrémités de ces pattes sur les languettes de la grille.

La phase suivante illustrée par la figure 7 consiste à remplir l'évidement 8 et les fenêtres 9 de chaque pastille, et éventuellement aussi l'espace qui entoure la puce dans la cavité 10, d'un matériau adhésif, isolant, durcissable et de préférence opaque pour protéger la puce 12 qu'elle contient contre la lumière au moins jusqu'à ce que le module soit inséré dans une carte. Ce matériau peut être par exemple une résine à base de silicone ou d'époxyde.

Il ne reste plus alors qu'à découper les languettes 3 en suivant le contour de chaque pastille 6 pour obtenir une série de modules comme celui qui est représenté, vu de face, sur la figure 8.

Cette dernière opération peut être exécutée par le fabricant de modules s'il ne produit pas lui-même les cartes, auquel cas ces modules seront livrés en vrac, généralement après avoir été testés, ou par le client.

Chaque module peut être ensuite collé dans un logement de forme correspondante prévu dans un corps de carte par exemple comme le montre la figure 9 et comme cela se fait le plus souvent, c'est-à-dire dans le coin situé en haut et à gauche de ce corps lorsqu'il est vu de face.

Ce logement peut être une ouverture si le module a la même épaisseur que le corps de carte ou une cavité si le module est plus mince. La deuxième solution présente au moins deux avantages par rapport à la première : la puce et les conducteurs sont mieux protégés et la surface de liaison entre le corps de carte et le module étant beaucoup plus grande, ce dernier risquera moins de se décoller par suite des déformations fréquentes et plus ou moins importantes auxquelles la carte sera soumise lorsqu'elle sera utilisée.

Enfin, pour en terminer avec ce premier mode de mise en oeuvre du procédé selon l'invention, il reste à indiquer pourquoi on a choisi de réaliser les modules sous la forme de disques plus épais au centre qu'à la périphérie plutôt qu'avec deux faces planes parallèles. La raison est que, de ce fait, les contraintes que subira le corps de carte lorsque celle-ci sera soumise à des flexions ou à des torsions seront sinon annihilées du moins très atténuées au niveau de la frontière entre les parties mince et épaisse du disque. La puce de circuit intégré, les conducteurs et les soudures au niveau des bornes de connexion de la puce et des plages de contact seront donc beaucoup mieux protégés du point de vue mécanique.

Le deuxième mode de mise en oeuvre de l'invention dont il va être question maintenant présente en fait beaucoup de points communs avec le premier. On s'emploiera donc surtout à préciser les différences qui existent entre les deux.

D'autre part, les mêmes objets ou parties de ceux-ci qui sont identiques ou équivalents à ceux ou celles dont il a été question jusqu'à présent seront désignés par les mêmes repères avec en plus le signe"'".

Ce deuxième mode de mise en oeuvre convient lorsque le substrat de la puce qui porte le circuit intégré doit être mis à la masse.

Ici encore, on commence par réaliser, d'une part, une grille 1' en forme de bande comme celle qui est représentée sur la figure 10 et, d'autre part, des pastilles 6' en matière synthétique comme celle qui est montrée de dos et de face respectivement sur les figures $11_a$ et $11_b$ et en coupe suivant la ligne brisée XI-XI de la figure $11_a$ sur la figure $11_c$.

La grille l' continue à présenter des perforations 5' pour son entraînement, des ouvertures 2' et des languettes 3' qui s'étendent à l'intérieur de celles-ci, mais dans chaque groupe de languettes il y en a une qui a une forme particulière. Cette languette est formée d'une partie principale droite $3_a'$ qui traverse l'ouverture dans laquelle elles se trouve en son milieu et qui est rattachée aux deux bouts au cadre 4' de la grille et d'une ramification $3_b'$ qui part de cette partie centrale pour aller se rattacher elle aussi au cadre et qui remplace l'une des languettes 3 de la grille de la figure 1. Quant aux autres languettes 3', elles conservent la même forme et la même disposition que précédemment.

Par ailleurs, chaque pastille se présente toujours sous la forme d'un disque avec une face avant $6_a'$ pratiquement plane, une partie périphérique $6_d'$ plus mince que la partie centrale $6_c'$ et un évidement 8' dans cette dernière.

Cependant, si l'on compare la pastille 6' des figures $11_a$ à $11_c$ avec celle, 6, des figures $2_a$ à $2_c$, on voit qu'il y a trois différences.

La première qui concerne les gorges que présentent les faces avant de ces pastilles s'impose. Il est clair en effet que l'une des gorges 7' doit comporter, elle aussi, une partie principale $7_a'$ et une ramification $7_b'$ pour que leur configuration soit adaptée à celle des languettes 3' de la grille 1'.

La deuxième est que la cavité 10 de la pastille pour la puce de circuit intégré a été remplacée par une ouverture 10' qui débouche dans la partie principale $7_a'$ de la gorge 7 particulière et la troisième tient au fait que l'évidement 8' de la pastille 6' n'a pas exactement la même forme que celui, 8, de la pastille 6 étant donné que l'une des fenêtres 9' débouche dans la partie principale de la gorge en question. En réalité, cette dernière différence est sans importance car on pourrait très bien la supprimer en faisant déboucher cette fenêtre dans la ramification $7_b'$.

Comme dans le premier mode de mise en oeuvre, les étapes suivantes consistent à fixer la pastilles 6' sur la grille 1' (voir figure 12), en utilisant de préférence le soudage par ultrasons, à coller des puces 12' dans les logements 10' qui leur sont réservés, à relier les bornes de connexion 13' de ces puces aux languettes 3' par des conducteurs 14', selon l'une ou l'autre des méthodes indiquées ci-dessus (voir figures $13_a$ et $13_b$, la figure $13_b$ étant une vue en coupe suivant la ligne brisée XIII-XIII de la figure $13_a$) et à combler les évidements 8' d'un matériau adhésif isolant 15' (voir figure 14), mais ici les puces 12' sont collées au moyen d'une colle conductrice sur les parties principales $3_a'$ des languettes 3' particulières qui, bien entendu, sont connectées à leurs bornes de masse.

Il ne reste plus ensuite qu'à séparer les modules de la grille et il y a pour cela deux possibilités.

La première est de découper en une seule fois toutes les languettes autour de chaque pastille. Ceci peut être fait par le fabricant de modules ou par le client à condition que celui-ci puisse tester lui-même ces modules.

La deuxième qui peut s'avérer souvent plus avantageuse et qui est illustrée par la figure 15 est de ne découper d'abord que les languettes qui, à l'origine, avaient une extrémité libre c'est-à-dire celles qui constituent les plages de contact qui ne sont pas reliées à la borne de masse d'une puce. La fabricant qui se charge alors de cette opération peut, après les avoir testés, fournir les modules en bande au client qui n'a plus qu'à découper les languettes particulières pour pouvoir insérer les modules dans des cartes.

Bien qu'elle ne soit pas exclue, cette deuxième solution n'a pas été envisagée dans le cadre du premier mode de mise en oeuvre car, dans ce cas, les modules ne seraient plus soutenus après la première phase de découpage que par une languette rattachée seulement par un bout à la grille, qui risquerait de se casser ou de s'arracher au moins partiellement de la pastille à laquelle elle est liée et la livraison en bande de ces modules ne pourrait pas s'effectuer sans précautions particulières.

Par contre, avec une languette qui reste fixée en trois points à la grille il n'y a plus ce problème.

Naturellement, l'invention n'est pas limitée aux deux modes de mise en oeuvre qui viennent d'être décrits.

Par exemple, plutôt que sous la forme d'une bande, la grille pourrait se présenter sous celle d'une plaque rectangulaire ou carrée, avec des ouvertures régulièrement réparties en lignes et en colonnes et qui pourrait être déplacée dans deux directions perpendiculaires devant les différents outils utilisés pour la fabrication de modules.

De même, il n'est pas obligatoire que les pastilles en matière synthétique qui définissent la forme des modules soient rondes. Elles pourraient aussi être rectangulaires, carrées ou autres.

Il peut arriver également, lorsqu'il n'y a pas besoin de mettre le substrat du circuit intégré à la masse, que la différence d'épaisseur entre la pastille et la puce soit suffisamment importante pour que l'on ne soit pas obligé de prévoir une cavité pour loger cette dernière et qu'on puisse la coller sur le fond alors plat de l'évidement de la pastille.

Par ailleurs, on a indiqué les avantages que présente le fait qu'il y ait une différence d'épaisseur entre les parties centrale et périphérique des pastilles mais cela n'exclut pas la possibilité de donner à ces pastilles une épaisseur constante.

En ce qui concerne les gorges qui sont destinées à recevoir les languettes, il est clair que leur présence est très utile car elles permettent aux modules d'avoir une face avant parfaitement plane et de ne pas pouvoir être accusés de créer des surépaisseurs lorsqu'ils sont placés dans des cartes. De plus, grâce à elles il n'y a pas le risque que les plages de contact soient arrachées lorsqu'elles sont simplement collées ou fixées par thermosoudage sur les pastilles. Malgré cela, on peut quand même envisager de les supprimer.

D'autre part, au lieu de souder les extrémités des conducteurs sur les bornes de connexion des puces et sur les languettes, on pourrait les coller en utilisant une colle conductrice.

Enfin, il est évident que l'on pourrait prévoir dans chaque module non pas une seule mais deux puces ou plus connectées entre elles, logées ou non dans la même cavité ou ouverture du fond de l'évidement de la pastille et dont une au moins serait reliée aux plages de contact.

## Revendications

1.  Procédé de fabrication de modules électroniques pour cartes à microcircuits, comprenant chacun une puce de circuit intégré avec une face avant munie de bornes de connexion et une face arrière et un ensemble de plages de contact métalliques reliées chacune à l'une des bornes de connexion de la puce, caractérisé par le fait que:

- on se munit d'une grille métallique (1; 1') comportant une pluralité d'ouvertures identiques (2; 2') délimitées par un cadre (4,; 4') et, dans chaque ouverture, un ensemble de languettes (3; 3') rattachées au cadre et destinées à former les plages de contact d'un module;
- on se munit également d'une série de pastilles (6; 6') en matière synthétique plus petites que les ouvertures de la grille, chaque pastille ayant une face avant ($6_a$; $6_a$') sensiblement plane, une face arrière ($6_b$; $6_b$') du côté de laquelle elle présente un évidement (8; 8') et, entre cet évidement et ladite face avant, des fenêtres (9; 9') prévues pour pouvoir être amenées chacune au droit d'une languette d'un ensemble;
- on fixe une pastille par sa face avant sur chaque ensemble de languettes de façon que lesdites fenêtres se trouvent effectivement au droit de ces languettes;
- on fixe une puce de circuit intégré (12,; 12') au fond de l'évidement de chaque pastille de façon que sa face arrière soit orientée vers la grille;
- on relie les bornes de connexion (13; 13') de la puce aux languettes sur lesquelles la pastille est fixée, au moyen de conducteurs (14; 14') logés dans l'évidement de la pastille et passant par lesdites fenêtres; et
- on remplit l'évidement et les fenêtres de chaque pastille d'un matériau adhésif durcissable (15; 15'), électriquement isolant.

2. Procédé selon la revendication 1, caractérisé par le fait que, pour fixer une puce (12; 12') à l'intérieur d'une pastille (6; 6') et relier ses bornes de connexion (13; 13') aux languettes (3; 3') de la grille (1; 1'), on commence par coller la puce dans le fond de l'évidement (8; 8') de la pastille et on soude ensuite chaque conducteur (14; 14'), d'une part, sur une borne de connexion de la puce et, d'autre part, sur la languette correspondante.

3. Procédé selon la revendication 1, caractérisé par le fait que, pour fixer les puces (12; 12') à l'intérieur des pastilles (6; 6') et relier leurs bornes de connexion (13; 13') aux languettes (3; 3') de la grille (1; 1'), on commence par souder les conducteurs (14; 14') par une de leurs extrémités sur les bornes de connexion des puces, on colle ensuite les puces dans le fond des évidements (8; 8') des pastilles et enfin on soude les autres extrémités des conducteurs sur les languettes.

4. Procédé selon l'une quelconque des revendications précédentes, caractérisé par le fait que les pastilles (6; 6') sont moulées par injection.

5. Procédé selon l'une quelconque des revendications précédentes, caractérisé par le fait que les pastilles (6; 6') sont en matière thermoplastique.

6. Procédé selon l'une quelconque des revendications précédentes, caractérisé par le fait que chaque pastille (6; 6') présente une partie centrale ($6_c$; $6_c$') dans laquelle se trouvent ledit évidement (8; 8') et lesdites fenêtres (9; 9') et une partie périphérique ($6_d$; $6_d$') plus mince que ladite partie centrale.

7. Procédé selon l'une quelconque des revendications précédentes, caractérisé par le fait que chaque pastille (6; 6') a la forme d'une disque.

8. Procédé selon l'une quelconque des revendications précédentes, caractérisé par le fait que ledit évidement (8; 8') présente un espace central ($8_a$; $8_a$') et un ensemble de rainures ($8_b$; $8_b$') partant de cet espace central, qui se prolongent jusqu'auxdites fenêtres (9; 9') et dans lesquelles passent lesdits conducteurs (14; 14').

9. Procédé selon l'une quelconque des revendications précédentes, caractérisé par le fait que les faces avant ($6_a$; $6_a$') des pastilles (6; 6') présentent des gorges (7; 7') ajustées à la forme et aux dimensions des languettes (3; 3'), dans lesquelles débouchent lesdites fenêtres (9; 9') et dans lesquelles lesdites languettes sont introduites au moment de la fixation desdites pastilles sur la grille (1; 1').

10. Procédé selon l'une quelconque des revendications précédentes, caractérisé par le fait que les languettes (3; 3') présentent sur leur pourtour des ergots (11) repliés sensiblement à angle droit et que la fixation des pastilles (6; 6') sur la grille (1; 1') est réalisée en faisant pénétrer ces ergots dans la matière synthétique au moyen d'ultrasons.

11. Procédé selon l'une quelconque des revendications précédentes, caractérisé par le fait que la grille (1; 1') est en maillechort.

12. Procédé selon l'une quelconque des revendications précédentes, caractérisé par le fait que chaque pastille (6) présente, au fond dudit évidement (8), une cavité (10) dans laquelle est logée ladite puce (12).

13. Procédé selon la revendication 12, caractérisé par le fait que les languettes (3) ont toutes la même forme rectangulaire et les mêmes dimensions et sont toutes rattachées au cadre (4) par une extrémité seulement, et que, dans chaque ouverture (2), ces languettes sont au nombre de huit et disposées parallèlement entre elles et symétriquement par rapport à un plan médian de cette ouverture.

14. Procédé selon la revendication 12 ou 13, caractérisée par le fait que l'on sépare aussi les modules de la grille (1) en découpant les languettes (3) autour de chaque pastille (6).

15. Procédé selon l'une quelconque des revendications 1 à 11, caractérisé par le fait que chaque ensemble de languettes (3') comprend une languette particulière avec une partie principale droite ($3_a'$), rattachée à ses deux extrémités au cadre (4') et située sensiblement au milieu de l'ouverture (2') dans laquelle elle se trouve et une ramification ($3_b'$) également rattachée au cadre, les autres languettes de l'ensemble étant simplement droites, rattachées par une extrémité seulement au cadre et réparties de part et d'autre de la partie principale de la languette particulière; que chaque pastille (6') présente, au fond dudit évidement (8'), en plus des fenêtres (9'), une ouverture (10') qui débouche sous la partie principale de la languette particulière de l'ensemble sur lequel elle est fixée et dans laquelle est logée ladite puce (12'), la face arrière de cette dernière étant collée au moyen d'une colle électriquement conductrice sur ladite partie principale; et que ladite languette particulière est reliée par l'un desdits conducteurs (14') à une borne de connexion (13') de masse que possède la puce.

16. Procédé selon la revendication 15, caractérisé par le fait que les autres languettes (3') de l'ensemble sont au nombre de sept, ont toutes la même forme rectangulaire et les mêmes dimensions et sont parallèles entre elles et à la ramification ($3_b'$) de la languette particulière qui est aussi rectangulaire et perpendiculaire à la partie principale ($3_a'$), et par le fait que ces languettes et ladite ramification sont disposées symétriquement par rapport à ladite partie principale.

17. Procédé selon la revendication 15 ou 16, caractérisé par le fait qu'après l'opération de remplissage des évidements (8') des pastilles (6') on découpe autour de celles-ci au moins lesdites autres languettes (3').

18. Procédé selon l'une quelconque des revendications précédentes, caractérisé par le fait que ledit matériau adhésif (15; 15') est une résine à base d'époxyde.

19. Procédé selon l'une quelconque des revendications 1 à 17, caractérisé par le fait que ledit matériau adhésif (15; 15') est une résine à base de silicone.

20. Procédé selon l'une quelconque des revendications précédentes, caractérisé par le fait que ladite grille (1; 1') est en forme de bande et que lesdites ouvertures (2; 2') sont régulièrement réparties dans le sens de sa longueur.

21. Module électronique pour carte à microcircuits, comprenant une puce de circuit intégré avec une face avant munie de bornes de connexion et une face arrière et un ensemble de plages de contact métalliques reliées aux bornes de connexion de la puce par des conducteurs respectifs, caractérisé par le fait qu'il comprend également une pastille (6; 6') en matière synthétique qui a une face avant ($6_a$; $6_a'$) sensiblement plane sur laquelle sont fixées les plages de contact (3; 3'), une face arrière ($6_b$; $6_b'$) du côté de laquelle elle présente un évidement (8; 8') ayant une paroi formant fond dans lequel est fixée la puce (12; 12') et, entre cet évidement et ladite face avant, des fenêtres (9; 9') qui débouchent au travers de cette paroi formant fond chacune derrière une plage de contact; ledit évidement (8; 8') présentant un espace central ($8_a$; $8_a'$) et un ensemble de rainures ($8_b$; $8_b'$) partant de cet espace central, qui se prolongent à la surface de la paroi formant fond jusqu'auxdites fenêtres (9; 9') et dans lesquelles passent lesdits conducteurs (14; 14') et en ce que lesdits conducteurs (14; 14') sont logés dans l'évidement de ladite pastille et passent par lesdites fenêtres, et que ledit évidement, lesdites fenêtres, l'espace central et les rainures sont remplis d'un matériau adhésif durcissable (15; 15') électriquement isolant.

22. Module électronique selon la revendication 21, caractérisé par le fait que ladite pastille (6; 6') est en matière thermoplastique.

23. Module électronique selon la revendication 21 ou 22, caractérisé par le fait que ladite pastille (6; 6') présente une partie centrale ($6_c$; $6_c'$) dans laquelle se trouve ledit évidement (8; 8') et lesdites fenêtres (9; 9') et une partie périphérique ($6_d$; $6_d'$) plus mince que ladite partie centrale.

24. Module électronique selon l'une quelconque des revendications 21 à 23, caractérisé par le fait que ladite pastille (6; 6') est en forme de disque.

25. Module électronique selon l'une quelconque des revendications 21 à 24, caractérisé par le fait que lesdites plages de contact (3; 3′) sont placées dans des gorges (7; 7′) ajustées à leur forme et à leurs dimensions que présente ladite face avant (6ₐ; 6ₐ′) de la pastille (6; 6′).

26. Module électronique selon l'une quelconque des revendications 21 à 25, caractérisé par le fait que lesdites plages de contact (3; 3′) sont fixées à la pastille (6; 6′) au moyen d'ergots (11) répartis sur leur pourtour et repliés sensiblement à angle droit qui pénètrent dans ladite pastille.

27. Module électronique selon l'une quelconque des revendications 21 à 26, caractérisé par le fait que lesdites plages de contact (3; 3′) sont en maillechort.

28. Module électronique selon l'une quelconque des revendications 21 à 27, caractérisé par le fait que la pastille (6) présente, au fond dudit évidement (8), une cavité (10) dans laquelle est collée la puce (12).

29. Module électronique selon la revendication 28, caractérisé par le fait que lesdites plages de contact (3) sont au nombre de huit, ont toutes la même forme droite et la même largeur et sont disposées parallèlement entre elles et symétriquement par rapport à un plan médian de ladite pastille (6).

30. Module électronique selon l'une quelconque des revendications 21 à 27, caractérisé par le fait qu'il comprend une plage de contact (3′) particulière avec une partie principale droite (3ₐ′) située sensiblement au milieu de la face avant (6ₐ) de la pastille (6) et coupant celle-ci en deux et une ramification (3ᵦ′). les autres plages étant simplement droites et réparties de part et d'autre de la partie principale de la plage particulière; que la pastille présente au fond dudit évidement (8′), en plus des fenêtres, une ouverture (10′) est prévue au travers de la paroi formant fond et qui débouche sous la partie principale de la plage particulière et dans laquelle est logée ladite puce (12), la face arrière de cette dernière étant collée au moyen d'une colle électriquement conductice sur ladite partie principale; et que ladite plage de contact particulière est reliée par l'un desdits conducteurs (14′) à une borne de connexion (13′) de masse que possède la puce.

31. Module électronique selon la revendication 30, caractérisé par le fait que la ramification (3ᵦ′) de la plage de contact particulière est sensiblement perpendiculaire à la partie principale (3ₐ′), que les autres plages de contact (3′) sont au nombre de sept et ont toutes la même largeur que la ramification, et que ces autres plages et ladite ramification sont disposées parallèlement entre elles et symétriquement par rapport à ladite partie principale.

32. Module électronique selon l'une quelconque des revendications 21 à 31, caractérisé par le fait que ledit matériau adhésif (15; 15′) est une résine à base d'époxyde.

33. Module électronique selon l'une quelconque des revendications 21 à 31, caractérisé par le fait que ledit matériau adhésif (15; 15′) est une résine à base de silicone.

**Patentansprüche**

1. Verfahren zur Herstellung von elektronischen Modulen für Mikroschaltungskarten, von denen jedes einen Chip mit einer integrierten Schaltung, mit einer mit Anschlußklemmen ausgestatteten Vorderseite und einer Hinterseite und einer Anordnung metallischer Kontaktbereiche, die jeder mit einer der Anschlußklemmen des Chip verbunden sind, enthält, dadurch gekennzeichnet, daß

- man ein metallisches Gitter (1; 1′) nimmt, das eine Vielzahl gleicher Öffnungen (2; 2′), die durch einen Rahmen (4; 4′) abgegrenzt sind, und in jeder Öffnung einen Satz Zungen (3; 3′), die am Rahmen angesetzt sind und zur Bildung der Kontaktbereiche eines Moduls bestimmt sind, enthält;
- man ebenso eine Anzahl Plättchen (6; 6′) aus Kunststoff nimmt, die kleiner als die Öffnungen des Gitters sind, wobei jedes Plättchen eine im wesentlichen ebene Vorderseite (6ₐ; 6ₐ′), eine Hinterseite (6ᵦ; 6ᵦ′) auf deren Seite es eine Vertiefung (8; 8′) aufweist und zwischen dieser Vertiefung und genannter Vorderseite Fenster (9; 9′) aufweist, die damit in den Bereich einer Zunge einer Baugruppe gebracht werden können;
- man ein Plättchen mit seiner Vorderseite auf jedem Satz von Zungen so befestigt, daß sich die genannten Fenster tatsächlich im Bereich dieser Zungen befinden;
- man einen Chip (12; 12′) mit einer integrierten Schaltung so am Boden der Vertiefung jedes Plättchens befestigt, daß seine Hinterseite gegen das Gitter ausgerichtet ist;
- man die Anschlußklemmen (13, 13′) des Chip mit den Zungen, auf denen das Plättchen befestigt ist, mittels Leitern (14; 14′), die in der Vertiefung des Plättchen untergebracht sind und durch die genannten Fenster durchgehen, verbindet; und

- man die Vertiefung und die Fenster jedes Plättchens mit einem härtbaren, elektrisch isolierenden Klebstoff (15; 15') ausfüllt.

2. Verfahren nach Anspruch 1, dadurch gekennzeichnet, daß man, um einen Chip (12; 12') im Inneren eines Plättchens (6; 6') zu befestigen, und seine Anschlußklemmen (13; 13') mit den Zungen (3; 3') des Gitters (1; 1') zu verbinden, mit dem Ankleben des Chip im Boden der Vertiefung (8, (8') des Plättchens beginnt und man anschließend jeden Leiter (14; 14') einerseits an einer Verbindungsklemme des Chip und anderseits an der entsprechenden Zunge anlötet.

3. Verfahren nach Anspruch 1, dadurch gekennzeichnet, daß man, um die Chips (12; 12') im Inneren von Plättchen (6; 6') zu befestigen und ihre Verbindungsklemmen (13; 13') an den Zungen (3; 3') des Gitters (1; 1') zu befestigen, mit dem Anlöten der Leiter (14; 14') mit einem ihrer Enden an den Anschlußklemmen der Chip beginnt, man anschließend die Chips im Boden der Vertiefungen (8; 8') der Plättchen anklebt und man schließlich die anderen Enden der Leiter an den Zungen anlötet.

4. Verfahren nach einem der vorhergehenden Ansprüche, dadurch gekennzeichnet, daß die Plättchen (6; 6') durch Spritzgießen geformt werden.

5. Verfahren nach einem der vorhergehenden Ansprüche, dadurch gekennzeichnet, daß die Plättchen (6; 6') aus thermoplastischem Material sind.

6. Verfahren nach einem der vorhergehenden Ansprüche, dadurch gekennzeichnet, daß jedes Plättchen (6; 6') einen Mittelteil ($6_c$; $6_c'$) aufweist, in dem sich die genannte Vertiefung (8; 8') und die genannten Fenster (9; 9') und ein Randbereich ($6_d$; $6_d'$), der dünner als der genannte Mittelbereich ist, befindet.

7. Verfahren nach einem der vorhergehenden Ansprüche, dadurch gekennzeichnet, daß jedes Plättchen (6; 6') die Form einer Scheibe hat.

8. Verfahren nach einem der vorhergehenden Ansprüche, dadurch gekennzeichnet, daß die genannte Vertiefung (8; 8') einen mittleren Raum ($8_a$; $8_a'$) und einen Satz von diesem mittleren Raum weggehender Nuten ($8_b$; $8_b'$), die sich bis zu den genannten Fenstern (9; 9') erstrecken und in denen die genannten Leiter (14; 14') verlaufen, aufweist.

9. Verfahren nach einem der vorhergehenden Ansprüche, dadurch gekennzeichnet, daß die Vorderseiten ($6_a$; $6_a'$) der Plättchen (6; 6') in der Form und in den Abmessungen den Zungen (3; 3') entsprechende Rillen (7; 7') aufweisen, in welchen die genannten Fenster (9; 9') münden und in welche die genannten Zungen bei der Befestigung der genannten Plättchen auf dem Gitter (1; 1') eingeführt werden.

10. Verfahren nach einem der vorhergehenden Ansprüche, dadurch gekennzeichnet, daß die Zungen (3; 3') an ihrem Umfang im wesentlichen im rechten Winkel abgebogene Vorsprünge (11) aufweisen und daß die Befestigung der Plättchen (6; 6') auf dem Gitter (1; 1') durch Eindringenlassen dieser Vorsprünge in den synthetischen Werkstoff mittels Ultraschall durchgeführt wird.

11. Verfahren nach einem der vorhergehenden Ansprüche, dadurch gekennzeichnet, daß das Gitter (1; 1') aus einer Nickel-Kupfer-Zink-Legierung besteht.

12. Verfahren nach einem der vorhergehenden Ansprüche, dadurch gekennzeichnet, daß jedes Plättchen (6) am Boden der genannten Vertiefung (8) eine Ausnehmung (10) aufweist,in welcher der genannte Chip (12) angeordnet ist.

13. Verfahren nach Anspruch 12, dadurch gekennzeichnet, daß alle Zungen (3) die gleiche rechteckige Form und die gleichen Abmessungen haben und alle mit nur einem Ende am Rahmen (4) angesetzt sind und daß diese Zungen in jeder Öffnung (2) acht sind und zueinander parallel und bezüglich einer Mittelebene dieser Öffnung symmetrisch angeordnet sind.

14. Verfahren nach Anspruch 12 oder 13, dadurch gekennzeichnet, daß man beim Abschneiden der Zungen (3) um jedes Plättchen (6) ebenso die Module vom Gitter (1) trennt.

15. Verfahren nach einem der Ansprüche 1 bis 11, dadurch gekennzeichnet, daß jeder Satz von Zungen (3') eine besondere Zunge mit einem geraden Hauptteil ($3_a'$), der an seinen beiden Enden am Rahmen (4') angesetzt und im wesentlichen in der Mitte der Öffnung (2') angeordnet ist, in welcher sie sich befindet und eine Abzweigung ($3_b'$), die ebenfalls am Rahmen angesetzt ist, aufweist, wogegen die anderen Zungen des Satzes einfach gerade sind, nur mit einem Ende am Rahmen angesetzt und beiderseits des Hauptteils der besonderen Zunge verteilt sind; daß jedes Plättchen (6') am Boden der genannten Vertiefung (8') weitere Fenster (9'), eine Öffnung (10'), die unter dem Hauptteil der besonderen Zunge des Satzes auf dem es befestigt ist, mündet und in welcher der genannte Chip (12') angeordnet ist, aufweist, wobei die Hinterseite dieses letzteren mittels eines elektrisch leitenden Klebers auf den genannten Hauptteil geklebt ist; und daß die genannte besondere Zunge über einen der genannten Leiter (14') mit einer Masse-Anschlußklemme (13'), die der Chip aufweist, verbunden ist.

16. Verfahren nach Anspruch 15, dadurch gekennzeichnet, daß die anderen Zungen (3') des Satzes sieben sind, alle die gleiche rechteckige Form und die gleichen Abmessungen zueinander haben und zur Abzweigung (3_b') der besonderen Zunge parallel sind, die auch rechteckig und rechtwinkelig zum Hauptteil (3_a') ist und dadurch, daß die Zungen und die genannte Abzweigung relativ zum Hauptteil symmetrisch angeordnet sind.

17. Verfahren nach Anspruch 15 oder 16, dadurch gekennzeichnet, daß man nach dem Ausfüllen der Vertiefungen (8') der Plättchen (6') um diese wenigstens die genannten anderen Zungen (3') abschneidet.

18. Verfahren nach einem der vorhergehenden Ansprüche, dadurch gekennzeichnet, daß der genannte Klebstoff (15; 15') ein Epoxiharz ist.

19. Verfahren nach einem der Ansprüche 1 bis 17, dadurch gekennzeichnet, daß der genannte Klebstoff (15; 15') ein Silikonharz ist.

20. Verfahren nach einem der vorhergehenden Ansprüche, dadurch gekennzeichnet, daß das genannte Gitter (1; 1') die Form eines Bandes hat und daß die genannten Öffnungen (2; 2') regelmäßig in seiner Längsrichtung verteilt sind.

21. Elektronisches Modul für Mikroschaltungskarten, enthaltend einen Chip mit einer integrierten Schaltung, mit einer Vorderseite, die mit Anschlußklemmen ausgestattet ist, und einer Hinterseite, und einem Satz metallischer Kontaktbereiche, die mit den Anschlußklemmen des Chip über entsprechende Leiter verbunden sind, dadurch gekennzeichnet, daß es ebenso ein Plättchen (6; 6') aus Kunststoff aufweist, das eine im wesentlichen ebene Vorderseite (6_a; 6_a'), auf der die Kontaktbereiche (3; 3') befestigt sind, eine Hinterseite (6_b; 6_b'), auf deren Seite es eine Vertiefung (8; 8') mit einem eine Wand bildenden Boden aufweist, in dem der Chip (12; 12') befestigt ist, und zwischen dieser Vertiefung und der genannten Vorderseite Fenster (9; 9') hat, von denen jedes quer durch den eine Wand bildenden Boden hinter einem Kontaktbereich mündet, wobei die genannte Vertiefung (8; 8') einen mittleren Raum (8_a; 8_a') und einen Satz von diesem mittleren Raum ausgehender Nuten (8_b; 8_b'), die sich an der Oberfläche der den Boden bildenden Wand bis zu den genannten Fenstern (9; 9') erstrecken, und in denen die genannten Leiter (14; 14') verlaufen, aufweist, und dadurch daß die genannten Leiter (14; 14') in der Vertiefung des genannten Plättchens angeordnet sind und durch die genannten Fenster durchgehen; und daß die genannte Vertiefung, die genannten Fenster, der mittlere Raum und die Nuten mit einem härtbaren, elektrisch isolierenden Klebstoff ausgefüllt sind.

22. Elektronisches Modul nach Anspruch 21, dadurch gekennzeichnet, daß das genannte Plättchen (6; 6') aus thermoplastischem Werkstoff besteht.

23. Elektronisches Modul nach Anspruch 21 oder 22, dadurch gekennzeichnet, daß das genannte Plättchen (6; 6') einen Mittelteil (6_c; 6_c'), in welchem sich die genannte Vertiefung (8; 8') und die genannten Fenster (9; 9') befinden und einen Randbereich (6_d; 6_d'), der dünner als der genannte Mittelteil ist, aufweist.

24. Elektronisches Modul nach einem der Ansprüche 21 bis 23, dadurch gekennzeichnet, daß das genannte Plättchen (6; 6') die Form einer Scheibe hat.

25. Elektronisches Modul nach einem der Ansprüche 21 bis 24, dadurch gekennzeichnet, daß die genannten Kontaktbereiche (3; 3') in Rillen (7; 7') angeordnet sind, die ihrer Form und ihren Abmessungen angepaßt sind und welche die genannte Vorderseite (6_a; 6_a') des Plättchens (6; 6') aufweist.

26. Elektronisches Modul nach einem der Ansprüche 21 bis 25, dadurch gekennzeichnet, daß die genannten Kontaktbereiche (3; 3') an den Plättchen (6; 6') mittels an ihrem Umfang verteilten und im wesentlichen im rechten Winkel abgebogenen Vorsprüngen (11), die in das genannte Plättchen eindringen, befestigt sind.

27. Elektronisches Modul nach einem der Ansprüche 21 bis 26, dadurch gekennzeichnet, daß die genannten Kontaktbereiche (3; 3') aus einer Nickel-Kupfer-Zink-Legierung bestehen.

28. Elektronisches Modul nach einem der Ansprüche 21 bis 27, dadurch gekennzeichnet, daß das Plättchen (6) am Boden der genannten Vertiefung (8) eine Ausnehmung (10) aufweist, in die der Chip (12) geklebt ist.

29. Elektronisches Modul nach Anspruch 28, dadurch gekennzeichnet, daß die genannten Kontaktbereiche (3) acht sind, die gleiche gerade Form und die gleiche Größe haben, und zueinander parallel und zu einer Mittelebene des genannten Plättchens (6) symmetrisch sind.

30. Elektronisches Modul nach einem der Ansprüche 21 bis 27, dadurch gekennzeichnet, daß es einen besonderen Kontaktbereich (3') mit einem geraden Hauptteil (3$_a$'), der im wesentlichen in der Mitte der Vorderseite (6$_a$) des Plättchens (6) angeordnet ist und dieses zweiteilt und eine Abzweigung (3$_b$') enthält, wobei die anderen Bereiche einfach gerade und beiderseits des Hauptteils des besonderen Bereiches verteilt sind; daß das Plättchen am Boden der genannten Vertiefung (8'), zusätzlich zu den Fenstern, eine Öffnung (10') aufweist, die sich quer durch den eine Wand bildenden Boden erstreckt, und die unter dem Hauptteil des besonderen Bereiches mündet und in welcher der genannte Chip (12) angeordnet ist, wobei die Hinterseite des letzteren mittels eines elektrisch leitenden Klebers auf den genannten Hauptteil geklebt ist; und daß der genannte, besondere Kontaktbereich mittels eines der genannten Leiter (14') mit einer Masse-Anschlußklemme (13'), die der Chip aufweist, verbunden ist.

31. Elektronisches Modul nach Anspruch 30, dadurch gekennzeichnet, daß die Abzweigung (3$_b$') des besonderen Kontaktbereiches im wesentlichen rechtwinkelig zum Hauptteil (3$_a$') ist, daß die anderen Kontaktbereiche (3') sieben sind und die gleiche Größe wie die Abzweigung aufweisen und daß die anderen Bereiche und die genannte Abzweigung zueinander parallel und zum genannten Hauptteil symmetrisch angeordnet sind.

32. Elektronisches Modul nach einem der Ansprüche 21 bis 31, dadurch gekennzeichnet, daß der genannte Klebstoff (15; 15') ein Epoxiharz ist.

33. Elektronisches Modul nach einem der Ansprüche 21 bis 31, dadurch gekennzeichnet, daß der genannte Klebstoff (15; 15') ein Silikonharz ist.

**Claims**

1. A process for fabricating electronic modules for microcircuit cards, each module comprising an integrated circuit chip with a front face provided with connecting terminals and a rear face and a set of metal contact areas each connected to one of the chip's connecting terminals, said process being characterized in that it comprises the following steps :
   - providing a metal grid (1; 1') comprising a plurality of identical openings (2; 2') defined by a frame (4; 4') and, in each opening, a set of tongues (3; 3') attached to the frame for forming the contact areas of a module;
   - providing a series of pellets (6; 6') of synthetic material, these being smaller than the openings in the grid and each one having a generally flat front face (6$_a$; 6$_a$'), a rear face (6$_b$; 6$_b$') in which there is located a hollow (8; 8') and, between this hollow and said front face, windows (9; 9') so arranged that they can be positioned opposite the tongues respectively of one of said sets of tongues;
   - attaching a pellet by its front face to each set of tongues in such a way that said windows are actually opposite these tongues;
   - attaching an integrated circuit chip (12; 12') to the bottom of said hollow in each said attached pellet so that the rear face of said integrated circuit is directed towards the said grid;
   - connecting said chip's connecting terminals (13; 13') to said tongues to which said pellet is attached by means of conductors (14; 14') located in the hollow in said pellet and passing through said windows; and
   - filling said hollow and said windows in each said pellet with an electrically insulating, hardenable, adhesive material (15; 15').

2. A process according to claim 1, characterised in that to fix a chip (12; 12') inside a pellet (6; 6') and connect its connecting terminals (13; 13') to said tongues (3; 3') in said grid (1; 1'), said chip is first bonded to the bottom of said hollow (8; 8') in said pellet and then each said conductor (14; 14') is soldered at one hand to one of said chip's connecting terminals and, at the other hand, to the corresponding tongue.

3. A process according to claim 1, characterised in that to fix said chips (12; 12') inside said pellets (6; 6') and connect their connecting terminals (13; 13'). to said tongues (3; 3') in the said grid (1; 1'), said conductors (14; 14') are first soldered at one of their ends to said chip's connecting terminals, then said chips are bonded to the bottoms of said hollows (8; 8') in said pellets and finally the other conductor ends are soldered to said tongues.

4. A process according to anyone of the preceding claims, characterised in that the pellets (6; 6') are injection moulded.

5. A process according to anyone of the preceding claims, characterised in that the pellets (6; 6') are of thermoplastic material.

6. A process according to anyone of the preceding claims, characterised in that each pellet (6; 6') has a central part (6$_c$; 6$_c'$) in which there are located said hollow (8; 8') and said windows (9; 9'), and a peripheral part (6$_d$; 6$_d'$) which is thinner than said central part.

7. A process according to anyone of the preceding claims, characterised in that each pellet (6; 6') is in the form of a disk.

8. A process according to anyone of the preceding claims, characterised in that said hollow (8; 8') has a central space (8$_a$; 8$_a'$) and a set of grooves (8$_b$; 8$_b'$) extending from said central space to said windows (9; 9') in which pass said conductors (14; 14').

9. A process according to anyone of the preceding claims, characterised in that the front faces (6$_a$; 6$_b'$) of the pellet (6; 6') have channels (7; 7') adapted to the shape and dimensions of one said tongues (3; 3'), into which channels said windows (9; 9') open and into which said tongues are introduced when said pellets are fixed on to the grid (1; 1'),

10. A process according to anyone of the preceding claims, characterised in that the tongues (3; 3') have lugs (11) along their sides which are folded over generally at right angles and in that the pellets (6; 6') are fixed to the grid (1; 1') by causing the lugs to penetrate said synthetic material by ultrasonic means.

11. A process according to anyone of the preceding claims, characterised in that the grid (1; 1') is of nickel silver.

12. A process according to anyone of the preceding claims, characterised in that each pellet (6) has, at the bottom of said hollow (8) a cavity (10) into which said chip (12) is placed.

13. A process according to claim 12, characterised in that the tongues (3) all have the same rectangular shape and the same dimensions and are all attached to the frame (4) by one end only, and in that, in each opening (2), these tongues are eight in number and arranged in parallel with each other and symmetrically in relation to a median plane of this opening.

14. A process according to claim 12 or 13, characterised in that the modules are separated from the grid (1) by cutting the tongues (3) around each pellet (6).

15. A process according to anyone of claims 1 to 11, characterised in that each set of tongues (3') comprises a special tongue with a straight main part (3$_a'$) attached at its two ends to the frame (4') and situated approximatively in the middle of the opening (2') in which it is located, and a branch (3$_b'$) also attached to the frame, the other tongues of the set being simply straight, attached by only one end to the frame and distributed on each side of the main part of the special tongue; in that each pellet (6') has, at the bottom of said hollow (8') and in addition to the windows (9'), an opening (10') which opens under the main part of the special tongue of the set to which it is fixed and in which said chip (12') is seated, said chip's rear face being bonded by means of an electrically conductive adhesive to said main part; and in that said special tongue is connected by one of said conductors (14') to an earth connecting terminal (13') with which said chip is provided.

16. A process according to claim 15, characterised in that other tongues (3') of the set number seven, all have the same rectangular shape and the same dimensions and are parallel to each other and to the branch (3') of the special tongue, said branch also being rectangular and perpendicular to the main part (3$_a'$), and in that these tongues and said branch are arranged symmetrically in relation to said main part.

17. A process according to claim 15 or 16, characterised in that after the hollows (8') in the pellets (6') are filled, at least said other tongues (3') are cut round said pellets.

18. A process according to anyone of the preceding claims, characterised in that said ahesive material (15; 15') is an epoxy-based resin.

19. A process according to anyone of claims 1 to 17, characterised in that said adhesive material (15; 15') is of silicone-based resin.

20. A process according to anyone of the preceding claims, characterised in that said grid (1; 1') is in the form of a strip with said openings (2; 2') spread at regular intervals therealong.

21. An electronic module for microcircuits cards, comprising an integrated circuit chip with a front face fitted with connecting terminals and a rear face and a set of metal contact, areas connected to the chip's connecting terminals by respective conductors, characterised in that it further comprises a pellet (6; 6') of synthetic material which has a generally flat front face ($6_a$; $6_a$') to which are attached the contact areas (3; 3'), a rear face ($6_b$; $6_b$') having a hollow (8; 8') with a wall forming a bottom in which said chip (12, 12') is attached and, between said hollow and said front face, windows (9; 9') which each open through this wall forming a bottom behind a contact area, said hollow (8; 8') having a central space ($8_a$; $8_a$') and a set of grooves ($8_b$; $8_b$') extending on the surface of the wall forming a bottom from said central space to said windows (9; 9') and in which pass said conductors (14; 14'); and in that said conductors (14; 14') are located in the hollow of said pellet and pass through said windows; and in that said hollow, said windows, the central space and the grooves are filled with an electrically insulating, hardenable, adhesive material (15; 15').

22. An electronic module according to claim 21, characterised in that said pellet (6; 6') is of thermoplastic material.

23. An electronic module according to claim 21 or 22, characterised in that said pellet (6; 6') has a central part ($6_c$; $6_c$') in which there are located said hollow (8; 8') and said windows (9; 9') and a peripheral part ($6_d$; $6_d$') which is thinner than said central part.

24. An electronic module according to anyone of claims 21 to 23, characterised in that said pellet (6; 6') is in the shape of a disk.

25. An electronic module according to anyone of claims 21 to 24, characterised in that said contact areas (3; 3') are disposed in channels (7; 7') adapted to their shape and dimensions and said channels being located in said front face ($6_a$; $6_a$') of said pellet (6; 6').

26. An electronic module according to anyone of claims 21 to 25, characterised in that said contact areas (3; 3') are attached to the pellet (6; 6') by means of lugs (11) distributed around their sides and folded over generally at right angles, said lugs penetrating into said pellet.

27. An electronic module according to anyone of claims 21 to 26, characterised in that said contact areas (3; 3') are of nickel silver.

28. An electronic module according to anyone of claims 21 to 27, characterised in that the pellet (6) has, at the bottom of said hollow (8), a cavity (10) in which the chip (12) is bonded.

29. An electronic module according to claim 28, characterised in that said contact areas (3; 3') are height in number, all have the same straight form and the same width and are arranged in parallell with each other and symmetrically in relation to a median plane of said pellet (6).

30. An electronic module according to anyone of claims 21 to 27, characterised in that it comprises a special contact area (3') with a straight main part ($3_a$') located approximately in the middle of and bisecting the front face ($6_a$) of the pellet (6) and a branch part ($3_b$'), the other contact areas being simply straight and distributed either side of the main part of the special contact area; in that the pellet has at the bottom of said hollow (8'), in addition to the windows, an opening (10') is provided through the wall forming a bottom and which opens under the main part of the special contact area and in which said chip (12) is seated, the rear face of said chip being bonded by means of an electrically conductive adhesive to said main part; and in that said special contact area is connected by one of said conductors (14') to an earth connecting terminal (13') with which said chip is provided.

31. An electronic module according to claim 30, characterised in that said branch part ($3_b$') of the special contact area is generally perpendicular to the main part ($3_a$'), in that the other contact areas (3') are seven in number and all have the same width as said branch part and in that these other contact areas and said branch part are arranged parallel to each other and symmetrically in relation to said main part.

32. An electronic module according to anyone of claims 21 to 31, characterised in that said adhesive material (15; 15') is an epoxy-based resin.

33. An electronic module according to anyone of claims 21 to 31, characterised in that said adhesive material (15; 15') is a silicone-based resin.

Fig.1

Fig.2$_a$

Fig.2$_b$

Fig.2c

Fig.3

Fig.6a

Fig.4

Fig.5a

Fig.5b

Fig. 6

Fig. 7

Fig. 8

Fig. 9

Fig.10

Fig.11a

Fig.11b

Fig. 11c

Fig. 12

Fig. 13a

Fig. 13ᵦ

Fig. 14

Fig. 15